# EUROPÄISCHE PATENTSCHRIFT

(11) **EP 0 812 528 B1**
(45) Veröffentlichungstag und Bekanntmachung des Hinweises auf die Patenterteilung: **26.08.1998**
(21) Anmeldenummer: 96901238.4
(22) Anmeldetag: 06.02.1996
(51) Int. Cl.: H05K 9/00

(54) **EMV-GERECHTER ELEKTRISCHER ANSCHLUSS**
ELECTRICAL CONNECTION WITH EMC
RACCORDEMENT ELECTRIQUE ASSURANT UNE COMPATIBILITE ELECTROMAGNETIQUE

(30) Priorität: 27.02.1995 DE 19506801
(43) Veröffentlichungstag der Anmeldung: 17.12.1997
(73) Patentinhaber: Siemens Nixdorf Informationssysteme AG, 33106 Paderborn (DE)
(72) Erfinder: JOHN, Hans-Jörg, D-33100 Paderborn (DE); PALAND, Rolf, D-34393 Grebenstein (DE)
(74) Vertreter: Epping, Wilhelm, Dr.-Ing.
(86) Internationale Anmeldenummer: DE9600181
(87) Internationale Veröffentlichungsnummer: WO9627281

(56) Entgegenhaltungen:
- EP-A- 0 383 357
- EP-A- 0 534 372
- PATENT ABSTRACTS OF JAPAN vol. 95, no. 002 & JP,A,07 035962 (NEC CORP;OTHERS: 01), 7.Februar 1995,

## Beschreibung

Die Erfindung betrifft eine Kombination aus einem Baugruppenträger mit einem abschirmenden Gehäuse, in dem eine Verbindungsrückwand mit Rückwandsteckern für die elektrische Verbindung von in den Baugruppenträger einsteckbaren Leiterplatten untereinander und/oder mit anderen Baugruppen angeordnet ist, und einer Leiterplatte, von der eine elektrische Leitung EMV-gerecht zu einem elektrischen Anschluß aus dem Gehäuse herausgeführt ist.

Aus der DE-A-39 07 278 oder EP-A-0 383 357 ist ein Übergabesystem für elektrische Signale bekannt, bei dem in einem abschirmenden Gehäuse Leiterplatten mit darauf angeordneten elektronischen Schaltungen parallel zueinander angeordnet sind. Das quaderförmige Gehäuse ist durch Metallwände nach fünf Seiten EMV-gerecht verschlossen. An der Stirnseite jeder Leiterplatte ist eine metallene Frontblende angebracht, die unmittelbar an eine benachbarte Frontblende oder eine Seitenwand des Gehäuses angrenzt und mit ihr in galvanischem Kontakt steht. Die Aneinanderreihung der Frontblenden bildet die sechste Gehäusewand. Ein aus dem Gehäuse herausführender elektrischer Anschluß einer Leiterplatte ist als Stecker ausgebildet, der die Frontblende durchsetzt.

Die bekannte Anordnung gewährleistet nur dann einen EMV-gerechten Verschluß des Gehäuses, wenn die sechste Gehäuseseite durch Frontblenden oder Blindelemente lückenlos verschlossen ist. Die EMV-gerechte Herausführung der elektrischen Anschlüsse aus dem abschirmenden Gehäuse ist schon deshalb technisch aufwendig und somit teuer, weil für jeden verwendeten Steckertyp eine spezielle Blende vorgehalten werden muß. Darüber hinaus muß jede Leiterplatte mit einer Frontblende versehen sein, auch wenn sie keinen elektrischen Anschluß nach außen besitzt. Nicht belegte Steckplätze für Leiterplatten müssen durch ein Blindelement in Frontplattenform verschlossen werden. Hinzu kommen Kontaktstreifen an den Längsseiten der Frontplatten und Blindelemente, die den galvanischen Kontakt zum Nachbarn herstellen.

Bei dem bekannten Übergabe system für elektrische Signale werden Verbindungen von dem im abschirmenden Gehäuse befindlichen Datenverarbeitungsgerät zunächst auf eine Rückwand geführt, die das abschirmende Gehäuse von dem eigentlichen Übergaberaum trennt. Die Bestückung eines Datenverarbeitungsgerätes kann aber nach Art und Anzahl der darin verwendeten Leiterplatten und der daran anzuschließenden Peripheriegeräte stark variieren. Die Rückwand muß also entweder mit einer für die maximale Bestückung des Datenverarbeitungsgerätes erforderlichen Anzahl von Steckern versehen sein, die zudem die maximal zu erwartende Polzahl aufweisen müssen, oder für die unterschiedlichen Bestückungsvarianten müssen unterschiedliche Rückwände vorgehalten werden. Beide Lösungen sind schon wegen der hohen Kosten nicht praktikabel.

Es ist die Aufgabe der Erfindung, einen Baugruppenträger für die EMV-gerechte Aufnahme unterschiedlich bestückter steckbarer Leiterplatten in beliebiger Kombination und beliebigem Belegungsgrad der vorhandenen Steckplätze sowie eine Leiterplatte anzugeben, von der eine elektrische Leitung EMV-gerecht zu einem elektrischen Anschluß aus dem Gehäuse herausgeführt ist, wobei ohne zusätzliche mechanische Konstruktionselemente an der Leiterplatte die EMV-gemäße Dichtheit des Gehäuses gewährleistet ist.

Die Aufgabe wird durch die Merkmale des Anspruchs 1 gelöst.

Die Erfindung geht von der Erkenntnis aus, daß eine großflächige elektrisch leitende Beschichtung auf einer Leiterplatte eine gute Schirmwirkung für hochfrequente elektrische Störungen aufweist. Schließt man elektrische Verbindungsleitungen -bei Leiterplatten sind dies im allgemeinen Leiterbahnen- zwischen solchen Beschichtungen ein, so können diese keine elektromagnetischen Störsignale in die Umgebung aussenden. Bei mehrlagigen Leiterplatten können hochfrequente Signale führende Leiterbahnen besonders vorteilhaft auf einer Innenlage geführt und die Außenlagen elektrisch leitend beschichtet sein. Auf diese Weise lassen sich Signal- und Spannungsversorgungsleitungen an elektrische Verbindungselemente, z.B. Stecker, Klemm- oder Lötleisten, EMV-gerecht heranführen.

Die Erfindung bezieht die beschichteten Flächen einer in dem Gehäuse angeordneten Leiterplatte in den Schirm des Gehäuses mit ein, indem die Leiterplatte durch einen Schlitz in einer Wand des Gehäuses aus diesem herausragt. Verbindungselemente für aus dem Gehäuse herausführende elektrische Anschlüsse sind auf dem aus dem Gehäuse ragenden Teil der Leiterplatte angeordnet.

Zur Herstellung einer elektrischen Verbindung zwischen der Wand und den beschichteten Flächen der Leiterplatte sind zumindest die Längsränder des Schlitzes mit elastisch verformbaren, elektrisch leitenden Kontaktstreifen versehen, die sich an die Leiterplatte anlegen und mit deren beschichteten Flächen kontaktieren. Durchragt keine Leiterplatte den Schlitz, legen sich die Kontaktstreifen aneinander und verschließen den Schlitz. Dies hat den Vorteil, daß das Gehäuse auch bei nur teilweiser Bestückung mit Leiterplatten stets EMV-gerecht verschlossen ist. Es ist auch möglich, Leiterplatten unterschiedlicher Länge, insbesondere kürzere, nicht aus dem abschirmenden Gehäuse ragende Leiterplatten zu verwenden, ohne die Schirmwirkung des Gehäuses zu beeinträchtigen.

Weitere Merkmale und vorteilhafte Weiterbildungen der Erfindung sind der nachfolgenden Beschreibung und der Zeichnung von Ausführungsbeispielen zu entnehmen. Es zeigt
- Fig. 1: eine schematische Draufsicht auf ein aufgeschnittenes Computergehäuse mit einer Leiterplatte gemäß einem ersten Ausführungsbeispiel,
- Fig. 2: einen Ausschnitt aus einer mit einem Schlitz versehenen Wand in Vorderansicht mit einer Leiterplatte gemäß einem zweiten Ausführungsbeispiel.

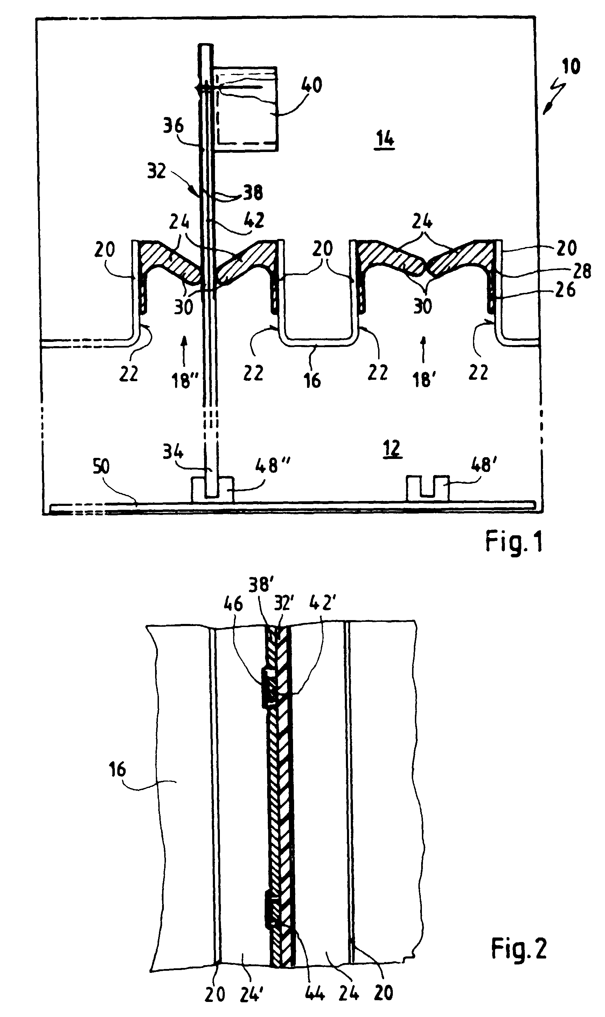

Fig.1 zeigt schematisch ein Computergehäuse 10 in Draufsicht. Es besteht aus zwei Teilen: Einem abschirmenden Gehäuse 12 und einem Kabelanschlußraum 14. Eine an den Kabelanschlußraum 14 grenzende Wand 16 des Gehäuses 12 ist mit Schlitzen 18', 18'' versehen, deren Längsränder 20 rechtwinklig in Richtung des Kabelanschlußraumes 14 abgebogen sind. Jedem Schlitz 18', 18'' ist ein Rückwandstecker 48', 48'' räumlich zugeordnet. Diese sind auf einer im Gehäuse 12 der geschlitzten Wand 16 gegenüberstehenden Verbindungsrückwand 50 angeordnet.

Auf die einander zugewandten Flächen 22 der abgebogenen Randbereiche sind elektrisch leitende Kontaktstreifen 24 aufgebracht. Die Kontaktstreifen 24 bestehen aus Moosgummi, das mit einem elektrisch leitenden Drahtgeflecht oder mit einer metallbeschichteten Kunststoffgaze überzogen und/oder selbst leitfähig ist. Der Kontaktstreifen 24 hat ein V-förmiges Profil. Der eine V-Schenkel 26 ist mit Hilfe eines doppelseitig haftenden Klebebandes 28, das nur einen Teil der Auflagefläche des V-Schenkels 26 auf der Fläche 22 bedeckt, auf letztere aufgeklebt. Eine elektrisch leitende Verbindung zwischen dem Kontaktstreifen 24 und der Wand 16 wird über die nicht von dem Klebeband 28 bedeckten Teilflächen hergestellt. Statt eines Klebebandes kann auch ein Kleber, vorzugsweise ein elektrisch leitender Kleber, verwendet werden.

Die freien V-Schenkel 30 einander gegenüberliegender Kontaktstreifen 24 berühren einander, wie das bei einem ersten Schlitz 18' gezeigt ist. Dieser Schlitz ist damit EMV-gerecht verschlossen. In einen zweiten Schlitz 18" ist eine Leiterplatte 32 eingesteckt. Diese ragt mit einer ersten Teilfläche 34 in das abschirmende Gehäuse 12, wo sie in den dem Schlitz 18" gegenüberstehenden Rückwandstecker 48" eingesteckt ist. Mit einer zweiten Teilfläche 36 ragt die Leiterplatte 32 in den Kabelanschlußraum 14. Auf der ersten Teilfläche 34 können elektrische Schaltungen angeordnet sein. Ferner kann eine Leiterplatte 32 innerhalb des abschirmenden Gehäuses 12 über die Verbindungsrückwand 50, welche eine nicht dargestellte elektrische Verdrahtung trägt, mit in andere Rückwandstecker 48 eingesteckten weiteren Leiterplatten 32 und/oder mit ebenfalls nicht dargestellten, auf der Verbindungsrückwand 50 oder diskret von dieser angeordneten Baugruppen, z.B. einer Stromversorgung oder einem Massenspeicher verbunden sein.

Die in den Kabelanschlußraum 14 ragende zweite Teilfläche 36 der Leiterplatte 32 ist beiderseits mit einer elektrisch leitenden Beschichtung 38 versehen. Diese wird zweckmäßigerweise durch die Kupferkaschierung dargestellt, aus der ohnehin die auf Leiterplatten befindlichen Leiterbahnen gebildet sind. Diese elektrisch leitenden Beschichtungen 38 sind im Kabelanschlußraum umlaufend am Leiterplattenrand mit nicht dargestellten Durchkontaktierungen verbunden. Der Abstand der Durchkontaktierungen zur Verbindung der leitenden Beschichtung 38 auf den Außenseiten richtet sich nach der kleinsten abzuschirmenden Wellenlänge. Alternativ oder zusätzlich zu dieser Maßnahme kann die leitende Beschichtung 38 auch um die Ränder der Leiterplatte 32 herumgeführt sein. Die Beschichtung 38 erstreckt sich so weit in den zweiten Schlitz 18", daß die freien Schenkel 30 der Kontaktstreifen 24 mit ihr kontaktieren können. Damit liegt die Beschichtung 38 auf dem gleichen Potential -im allgemeinen Massepotential- wie das abschirmende Gehäuse 12. Auf der in den Kabelanschlußraum 14 ragenden zweiten Teilfläche 36 der Leiterplatte 32 ist ein Stecker 40 angebracht, an dessen Kontaktstifte elektrische Signale und/oder Versorgungsspannungen über Leiterbahnen 42 auf einer Innenlage der Leiterplatte 32 herangeführt werden. Die aus dem abschirmenden Gehäuse 12 herausgeführten elektrischen Anschlüsse sind dadurch vollständig EMV-gerecht geführt.

Fig. 2 zeigt einen Ausschnitt aus einer mit einem Schlitz versehenen Wand 16 in Vorderansicht mit einer Leiterplatte 32' gemäß einem zweiten Ausführungsbeispiel der Erfindung. Die Leiterplatte 32' ist einseitig mit einer elektrisch leitenden Beschichtung 38' mit Aussparungen 44 beschichtet, in die Leiterbahnen 42' eingebettet sind. Im Bereich des Kontaktstreifens 24' sind die Leiterbahnen 42' mit einer Isolierschicht 46 überdeckt.

Das zweite Ausführungsbeispiel einer Herausführung von elektrischen Anschlüssen aus einem abschirmenden Gehäuse 12 ist auch für einlagige und/oder einseitig beschichtete Leiterplatten 32' geeignet. Obwohl die Aussparungen 44 und die Materialstärke der Leiterplatte 32' Unterbrechungen im Störstrahlungsschirm des abschirmenden Gehäuses 12 bilden, reicht dessen Schirmwirkung zur Abschirmung elektromagnetischer Störgrößen aus, insbesondere wenn deren Wellenlänge groß gegenüber den Abmessungen dieser Unterbrechungen ist.

Es sind verschiedene Abwandlungen in der Form der Wand 16 und der Kontaktsteifen 24 möglich, die von der Erfindung erfaßt sind:
- Die Längsränder 20 der Schlitze 18 müssen nicht relativ zur Wand 16 abgebogen sein, vielmehr können sie auch gestreckt sein.
- Statt V-förmiger Kontaktstreifen sind auch solche mit einem runden oder ovalen, ausgefüllten oder hohlen Querschnitt einsetzbar.
- Die Kontaktstreifen können mit einem Längsschlitz von der Breite der Materialstärke der Schlitzränder versehen sein, die ein Aufstecken der Kontaktstreifen auf die Längsränder 20 der Schlitze 18 erlauben.
- Es können auch Kontaktstreifen aus Metall, insbesondere aus Federblech verwendet werden, die im Berührungsbereich mit der elektrisch leitenden Beschichtung 38 der Leiterplatte 32 geschlitzt oder gefiedert oder mit Borsten aus einem elektrisch leitenden Material versehen sind.

Die in Fig.1 dargestellte Anordnung der Verbindungsrückwand 50 an der der geschlitzten Wand 16 gegenüberliegenden Wand des Gehäuses 12 ist besonders für Leiterplatten geeignet, deren Verbindungsstecker zur Verbindungsrückwand 50 und deren Steckverbinder 40 zur Außenwelt an einander gegenüberliegenden Seiten der Leiterplatte 32 angeordnet ist. Es ist ebenfalls möglich, die Verbindungsrückwand senkrecht zu der geschlitzten Wand 16 im Gehäuse 12 anzuordnen. Eine solche Anordnung ist besonders für Leiterplatten mit einer Bauform geeignet, wie sie beispielsweise von ISA-Bus-Zusatzkarten für PC (IEEE Proposal P996) bekannt ist.

## Patentansprüche

1. Kombination aus einem Baugruppenträger (10) mit einem abschirmenden Gehäuse (12), in dem eine Verbindungsrückwand (50) mit Rückwandsteckern (48) für die elektrische Verbindung von in den Baugruppenträger (10) einsteckbaren Leiterplatten untereinander und/oder mit anderen Baugruppen angeordnet ist, und einer Leiterplatte (32, 32'), von der eine elektrische Leitung EMV-gerecht zu einem elektrischen Anschluß (40) aus dem Gehäuse (12) herausgeführt ist, **gekennzeichnet** durch folgende Merkmale:
eine Wand (16) des abschirmenden Gehäuses (12) ist mit Schlitzen (18', 18") versehen, durch jeden hindurch vermag die im Gehäuse (12) befindliche Leiterplatte (32, 32') mit einer Teilfläche (36) aus dem Gehäuse (12) herauszuragen,
wenigstens eine elektrische Leitung (42) ist EMV-gerecht von einer im Gehäuse (12) befindlichen Teilfläche (34) der Leiterplatte (32,32') zu dem elektrischen Anschluß (40) auf der aus dem Gehäuse ragenden Teilfläche (36) der Leiterplatte (32, 32') herausgeführt,
die Leiterplatte (32, 32') trägt wenigstens auf der aus dem Gehäuse (12) ragenden Teilfläche (36) zumindest auf einer Seite eine signalfreie elektrisch leitende Beschichtung (38),
zumindest die Längsränder (20) der Schlitze (18', 18") sind mit elastisch verformbaren, elektrisch leitfähigen Kontaktstreifen (24, 24') versehen, die mit der Wand (16) elektrisch verbunden sind und sich aneinander oder bei Vorhandensein der einen Schlitz (18") durchdringenden Leiterplatte (32, 32') an deren Beschichtung (38, 38') unter Kontaktgabe anlegen.

2. Kombination (32) nach Anspruch 1, bei der beide Außenflächen der Leiterplatte (32) eine elektrisch leitende Beschichtung (38) tragen und die Zuführung elektrischer Signale und/oder von Versorgungsspannungen zu dem elektrischen Anschluß (40) über Leiterbahnen (42) auf einer Innenlage der Leiterplatte (32) erfolgt.

3. Kombination nach Anspruch 2, bei der die elektrisch leitenden Beschichtungen (38) auf den beiden Außenseiten an den Rändern der Leiterplatte (32) miteinander verbunden sind.

4. Kombination nach Anspruch 1, bei der die Zuführung elektrischer Signale und/oder von Versorgungsspannungen zu dem elektrischen Anschluß (40) über Leiterbahnen (42') auf einer Außenlage der Leiterplatte (32') erfolgt, die in Aussparungen (44) der elektrisch leitenden Beschichtung (38') eingebettet und zumindest im Berührungsbereich mit einem Kontaktstreifen (24') mit einer Isolierschicht (46) überzogen sind.

5. Kombination nach einem der Ansprüche 1 oder 4, bei der der Kontaktstreifen (24, 24') aus einem mit einem Drahtgeflecht oder einer metallbeschichteten Kunststoffgaze überzogenen Moosgummi oder aus elektrisch leitendem Moosgummi besteht.

6. Kombination nach einem der Ansprüche 1, 4 oder 5, bei der sich an die mit Schlitzen (18', 18") versehene Wand (16) des abschirmenden Gehäuses (12) ein Kabelanschlußraum (14) anschließt, der die aus dem Gehäuse (12) ragende(n) Teilfläche(n) (36) der Leiterplatte(n) (32, 32') umschließt.

## Claims

1. Combination comprising a subrack (10) with a screening housing (12) in which a connecting backplane (50) with backplane connectors (48) for electrically connecting printed circuit boards, which can be inserted into the subrack (10), to one another and/or to other modules is arranged, and a printed circuit board (32, 32') from which an electric line is led out of the housing (12) to an electrical connection (40) in a fashion exhibiting EMC, characterized by the following features:
a wall (16) of the screening housing (12) is provided with slits (18', 18") through each of which the printed circuit board (32, 32') located in the housing (12) can project with a subarea (36) from the housing (12),
at least one electric line (42) is led out in a fashion exhibiting EMC from a subarea (34) of the printed circuit board (32, 32') located in the housing (12) to an electrical connection (40) on the subarea (36) projecting from the housing, of the printed circuit board (32, 32'),
at least on the subarea (36) projecting from the housing (12), the printed circuit board (32, 32') carries a signal-free electrically conducting coating (38), at least on one side, and
at least the longitudinal edges (20) of the slits (18', 18") are provided with elastically deformable, electrically conductive contact strips (24, 24') which are electrically connected to the wall (16) and bear against one another or, given the presence of a printed circuit board (32, 32') penetrating one slit (18"), against the coating (38, 38') of said printed circuit board while making contact.

2. Combination (32) according to Claim 1, in which both outer surfaces of the printed circuit board (32) bear an electrically conducting coating (38), and the feeding of electric signals and/or of supply voltages to the electrical connection (40) is performed via conductor tracks (42) on an inner layer of the printed circuit board (32).

3. Combination according to Claim 2, in which the electrically conducting coatings (38) are connected to one another on the two outer sides at the edges of the printed circuit board (32).

4. Combination according to Claim 1, in which the feeding of electric signals and/or of supply voltages to the electrical connection (40) is performed via conductor tracks (42') on an outer layer of the printed circuit board (32'), which conductor tracks are embedded in recesses (44) of the electrically conducting coating (38') and, at least in the contact region, are coated with a contact strip (24') with an insulating layer (46).

5. Combination according to one of Claims 1 or 4, in which the contact strip (24, 24') comprises a sponge rubber coated with a wire mesh or a metal-coated plastic gauze, or comprises an electrically conducting sponge rubber.

6. Combination according to one of Claims 1, 4 or 5, in which adjoining the wall (16), provided with slits (18', 18"), of the screening housing (12) is a cable terminal compartment (14) which surrounds the subarea(s) (36) projecting from the housing (12), of the printed circuit board(s) (32, 32').

## Revendications

1. Combinaison d'un porte module (10) comportant un boîtier (12) de blindage, dans lequel est montée une paroi (50) arrière de liaison comportant des connecteurs (48) de paroi arrière pour la liaison de plaquettes à circuits imprimés enfichables dans le porte module (10) entre elles et/ou à d'autres composants, et d'une plaquette (32, 32') à circuits imprimés, dont l'une des lignes électriques sort, d'une manière assurant une compatibilité électromagnétique, du boîtier (12) pour aller à un raccordement (40) électrique, caractérisée par les dispositions suivantes :
une paroi (16) du boîtier (12) de blindage est munie de fentes (18', 18") par laquelle une surface (36) partielle de la plaquette (32, 32') à circuits imprimés se trouvant dans le boîtier (12) peut faire saillie du boîtier (12),
au moins une ligne (42) électrique est sortie d'une manière assurant une compatibilité électromagnétique d'une surface (34) partielle de la plaquette (32, 32') à circuits imprimés se trouvant dans le boîtier (12) au raccordement (40) électrique sur la surface (36) partielle de la plaquette (32, 32') à circuits imprimés faisant saillie du boîtier,
la plaquette (32, 32') à circuits imprimés porte au moins sur la surface (36) partielle faisant saillie du boîtier (12), d'au moins un côté, un revêtement (38) conducteur de l'électricité et exempt de signaux,
au moins les bords (20) longitudinaux des fentes (18,' 18") sont munis de bandes (24, 24') de contact déformables élastiquement, conductrices de l'électricité, qui sont reliées électriquement à la paroi (16) et qui s'appliquent les unes aux autres ou, lorsque la plaquette (32, 32') à circuits imprimés traversant une fente (18') est présente, sur le revêtement (38, 38') de cette plaquette à circuits imprimés, avec formation de contact.

2. Combinaison (32) suivant la revendication 1, dans laquelle les deux surfaces extérieures de la plaquette (32) à circuits imprimés portent un revêtement conducteur de l'électricité et dans laquelle l'envoi de signaux électriques et/ou de tensions d'alimentation au raccordement (40) électrique s'effectue par l'intermédiaire de pistes (42) conductrices ménagées sur une couche intérieure de la plaquette (32) à circuits imprimés.

3. Combinaison suivant la revendication 2, dans laquelle les revêtements (38) conducteurs de l'électricité présents des deux côtés extérieurs sur les bords de la plaquette (32) à circuits imprimés sont reliés entre eux.

4. Combinaison hybride suivant la revendication 1, dans laquelle l'envoi de signaux électriques et/ou de tensions d'alimentation au raccordement (40) électrique s'effectue par l'intermédiaire de pistes (42') conductrices qui sont ménagées sur une couche extérieure de la plaquette (32') à circuits imprimés, qui sont enrobées dans des évidements (44) du revêtement (38') conducteur de l'électricité et qui sont recouvertes au moins dans la zone de contact par une bande (24') de contact comportant une couche (46) isolante.

5. Combinaison suivant l'une des revendications 1 ou 4, dans laquelle les bandes (24, 24') de contact sont en un caoutchouc cellulaire recouvert d'une toile métallique ou d'une gaze de matière plastique à revêtement métallique ou en un caoutchouc cellulaire conducteur de l'électricité.

6. Combinaison suivant l'une des revendications 1, 4 ou 5, dans laquelle il fait suite à la paroi (16) du boîtier (12) de blindage munie de fentes (18', 18") une zone (14) de raccordement de câbles, qui entoure la surface (36) partielle ou les surfaces (36) partielles de la plaquette (32, 32') ou des plaquettes (32, 32') à circuits imprimés, faisant saillies du boîtier (12).
